# EUROPÄISCHE PATENTSCHRIFT

(11) **EP 2 978 126 B1**
(45) Veröffentlichungstag und Bekanntmachung des Hinweises auf die Patenterteilung: **15.01.2020**
(21) Anmeldenummer: 14401078.2
(22) Anmeldetag: 24.07.2014
(51) Int. Cl.: H02S 40/44, H02S 40/42

(54) **Solarmodultemperieranordnung**
Solar module tempering assembly
Système de thermorégulation de panneau solaire

(43) Veröffentlichungstag der Anmeldung: 27.01.2016
(73) Patentinhaber: Götz, Thomas, 88709 Hagnau (DE)
(72) Erfinder: Götz, Thomas, 88709 Hagnau (DE)
(74) Vertreter: Heyerhoff Geiger & Partner Patentanwälte PartGmbB

(56) Entgegenhaltungen:
- EP-A1- 1 669 682
- US-A1- 2009 288 705
- US-A1- 2012 000 508

## Beschreibung

Die Erfindung betrifft eine Solarmodultemperieranordnung mit einem Wärmeleitelement, einem Fluidleitungselement und einer Wärme leitenden Füll- und/oder Klebemasse.

Solarmodule werden üblicherweise als dachseitig installierte oder mobile Anlagen zur Erzeugung von Elektroenergie bzw. thermischer Energie aus Sonnenlicht eingesetzt.

Solarmodule zur photoelektrischen Energieerzeugung werden häufig als Photovoltaikmodule bezeichnet und umfassen mehrere Solarzellen. Solche Photovoltaikmodule erwärmen sich im Betrieb leicht auf über 80°C, wodurch eine deutliche Verringerung des photoelektrischen Wirkungsgrads der Solarzellen eintreten kann. Typischerweise verringert sich der Wirkungsgrad um bis zu 10 % pro 25 K Temperaturanstieg.

Die zur Erzeugung von thermischer Energie eingesetzten Solarmodule werden hingegen häufig als Solarthermiemodule bezeichnet und unter anderem als Flachkollektoren ausgeführt. Solche Module umfassen üblicherweise eine Vorrichtung zur Wärmeableitung von einer Kollektorfläche bzw. zum Wärmeabtransport in einen Energiespeicher.

Vor diesem Hintergrund wird deutlich, dass eine Temperierung von Solarmodulen - und zwar unabhängig davon, ob es sich um Photovoltaik- oder Solarthermiemodule handelt - von wesentlicher technischer Bedeutung ist.

Hierzu offenbart DE 42 06 931 A1 eine Kühlvorrichtung aus einem Blech für ein Photovoltaikmodul, um dem beschriebenen Wirkungsgradverlust entgegenzuwirken. An der Vorderseite des Blechs sind die Solarzellen angebracht und an dessen Rückseite sind Kühlrohre durch Schweißen befestigt.

Außerdem sind aus dem Stand der Technik verschiedene Temperiervorrichtungen für Solarthermiemodule bekannt. Beispielsweise offenbart DE 10 2008 022 391 A1 einen Absorber mit einem Absorberblech, einem Wärmeleitblech und einem Rohr, wobei eine ebene Fläche des Rohrs an einer ebenen Fläche des Wärmeleitblechs anliegt.

Weiter ist in US 2012/0000508 A1 eine Temperieranordnung für eine Photovolaikeinheit offenbart, welche einen Baugruppenträger, mehrere Fluidleitungselemente und eine Wärme leitende Füllmasse umfasst. Der Baugruppenträger weist mehrere abgesenkte Kanäle auf, in welchen Kanälen jeweils eine der Fluidleitungselemente angeordnet ist. Die Kanäle sind mit der Wärme leitende Füllmasse befüllt, sodass die Fluidleitungselemente vollständig bedeckt sind.

Ferner offenbart EP 1 669 682 A1 eine Faserzusammensetzung, eine Verwendung derselbigen als Wärmeleitstoff, ein Wärmetauscherelement mit dem Wärmeleitstoff und ein Verfahren zur Herstellung des Wärmetauscherelements. In dem Wärmetauscherelement wird eine Kühlleitung direkt in dem Wärmeleitstoff eingebettet.

Es ist eine Aufgabe der Erfindung, eine Solarmodultemperieranordnung mit guten Wärmeleitungseigenschaften anzugeben.

Diese Aufgabe wird durch eine Solarmodultemperieranordnung der eingangs genannten Art gelöst, bei der erfindungsgemäß das Wärmeleitelement aus einem Verbundwerkstoff besteht und einen Aufnahmebereich aufweist, das Fluidleitungselement in seiner Längsrichtung zumindest abschnittsweise am Aufnahmebereich angeordnet und über die Füll- und/oder Klebemasse mit dem Wärmeleitelement verbunden ist, wobei die Füll- und/oder Klebemasse einen Radialspalt zwischen dem Fluidleitungselement und dem Aufnahmebereich zumindest teilweise ausfüllt.

Die Erfindung geht hierbei von der Überlegung aus, dass übliche Solarmodultemperieranordnungen, insbesondere für Solarthermiemodule, oftmals ein Wärmeleitelement aus Kupferblech aufweisen, das zur Einsparung von Masse und - in Anbetracht hoher Kupferpreise - Kosten mit einer vergleichsweise geringen Blechstärke ausgeführt sein kann. Mit der Erfindung kann durch die Verwendung des Verbundwerkstoffs ein kostengünstiges und dennoch stabiles Wärmleitelement realisiert werden, mit dem große Wärmemengen bei vergleichsweise geringer Wärmestromdichte transportiert werden können.

Das Wärmeleitelement kann ein Blech, ein Formteil, eine Platte, ein Profilbauteil oder dergleichen aus dem Verbundwerkstoff sein. Das Wärmeleitelement kann Bestandteil einer übergeordneten Wärmeleiteinheit sein, das das Wärmeleitelement mit weiteren Komponenten, z.B. einem Überzug auf dem Wärmeleitelement oder einem in das Wärmeleitelement eingebrachten weiteren Element, enthält. Der Aufnahmebereich des Wärmeleitelements kann eine Aufnahmevertiefung für das Fluidleitungselement, insbesondere ein Kanal, eine Rinne, eine Ausnehmung oder dergleichen sein.

Der Verbundwerkstoff kann ein Teilchenverbundwerkstoff sein, der auch als Dispersionswerkstoff bezeichnet wird. Ebenfalls vorteilhaft ist ein Faserverbundwerkstoff, insbesondere mit einer ein Silikat aufweisenden Matrix und zweckmäßigerweise mit metallhaltigen Fasern und/oder weiteren Zuschlagstoffen, oder ein Schichtverbundwerkstoff, auch als Laminat bezeichnet. Vorteilhafterweise kann das Fluidleitungselement ein Rohr, ein Schlauch oder dergleichen sein.

Durch eine entsprechende Zusammensetzung des Verbundwerkstoffs kann eine vergleichsweise hohe Wärmeleitfähigkeit erreicht werden. Weiter von Vorteil, kann durch geeignete Zuschlagstoffe des Verbundwerkstoffs eine Anpassung des Wärmeausdehnungskoeffizienten des Wärmeleitelements an den Wärmeausdehnungskoeffizienten des Solarmoduls und/oder des Fluidleitungselements erreicht werden, wodurch thermisch bedingten mechanischen Spannungen und einer etwaigen Überbeanspruchung der Solarmodultemperieranordnung und/oder des Solarmoduls entgegengewirkt werden kann.

Weiterhin hat der Verbundwerkstoff den Vorteil, dass er sehr kostengünstig aus Recyclingmaterial, beispielsweise Altaluminium, hergestellt werden kann.

Die Wärme leitende Füll- und/oder Klebemasse kann ein Wärme leitender Klebstoff, insbesondere zum Fügen metallischer und/oder metallhaltiger Fügeteile, sein und einen gut Wärme leitenden Füllstoff aufweisen, beispielsweise ein Graphit, ein Metallpulver oder dergleichen. Zweckmäßigerweise enthält die Füll- und/oder Klebemasse ein Bindemittel, vorzugsweise ein hochtemperaturbeständiges Bindemittel, beispielsweise ein Alkalisilikat.

Durch die Verbindung des Wärmeleitelements mit dem Fluidleitungselement mit der Wärme leitenden Füll- und/oder Klebemasse und das Ausfüllen des Radialspalts mit der Wärme leitenden Füll- und/oder Klebemasse kann die Ausbildung von isolierenden Lufteinschlüssen verringert, insbesondere vermieden, und eine Vergrößerung der Wärmeübertragungsfläche zwischen den Bauteilen und somit ein guter Wärmeübergang zwischen den Bauteilen erreicht werden.

Die Temperieranordnung kann eine Anordnung zur Übertragung von Wärmeenergie zwischen einer Fläche und einem Wärmetransportmedium sein. Ein die Übertragung beschreibender Wärmefluss kann im Wesentlichen von der Fläche in das Wärmetransportmedium oder vice versa verlaufen, so dass die Temperieranordnung zu einem Heizen und/oder einem Kühlen der Fläche eingesetzt werden kann. Insofern ist die Erfindung nicht auf eine Solarmodultemperieranordnung und auch nicht allgemeiner auf eine Solareinheit beschränkt, sondern kann ebenso gut Verwendung finden in beliebigen anderen Bereichen, in denen eine Temperierung vorteilhaft ist. Beispiele können eine Temperierung eines Gehäuses, einer Baueinheit eines Automobils oder einer Verpackungseinheit sein oder das Temperieren eines Dachs, einer Fassade, einer Wandfläche, einer Decke eines Raums oder eines Fußbodens. Insofern ist die Erfindung auch allgemein gerichtet auf eine Temperieranordnung - oder eine Wandtemperieranordnung, eine Fußbodentemperieranordnung, Deckentemperieranordnung, Fassadentemperieranordnung, Dachtemperieranordnung, Gehäusetemperieranordnung, eine Temperieranordnung einer Baueinheit eines Fahrzeugs, einer Verpackungseinheit, einer Arbeitsmaschine oder dergleichen - mit einem Wärmeleitelement, einem Fluidleitungselement, einer Wärme leitenden Füll- und/oder Klebemasse und den Merkmalen des kennzeichnenden Teils des Anspruchs 1. Gleiches gilt analog für Anspruch 10 zur Herstellung einer allgemeinen bzw. speziellen anderen Temperieranordnung wie oben beschrieben. Entsprechend sind auch die im Folgenden beschriebenen Details der Erfindung generell und nicht auf ein Solarmodul beschränkt zu verstehen, auch wenn die Details der Einfachheit halber anhand eines Solarmoduls erklärt sind.

In einer vorteilhaften Ausführungsform der Erfindung ist das Wärmeleitelement ein Profilbauteil. Ein solches weist über insbesondere seine gesamte Länge ein gleiches Profil auf und ist einfach herstellbar. Weist das Wärmeleitelement eine Rinne als Aufnahmebereich auf, so kann das Fluidleitungselement in die Rinne eingefügt werden, so dass es mechanisch stabil eingebettet ist. Vorzugsweise enthält das Wärmeleitelement an zumindest einer Seite der Rinne einen Schenkel mit einer zumindest abschnittsweise ebenen Anlagefläche auf. Hiermit kann das Wärmeleitelement auf eine ebene Fläche des Solarmoduls großflächig angelegt und beispielsweise befestigt werden. In einem Thermosolarmodul kann der Schenkel eine große Fläche zum Aufnehmen von Sonnenstrahlen bilden.

Das Profilbauteil kann bevorzugt ein offenes und/oder symmetrisches, insbesondere ein dünnwandiges Profil, beispielsweise ein U-Profil, ein V-Profil, ein W-Profil oder dergleichen sein. Vorteilhafterweise kann das Profil bei einem Fertigungsschritt des Verbundwerkstoffs, beispielsweise bei einem Pressen, einen Rollpressen oder dergleichen, aufwandsgünstig unter Umgehung weiterer Verfahrens- bzw. Umformschritte geformt werden.

Der Querschnitt der Rinne kann bevorzugt zur vollständigen Aufnahme des Querschnitts des Fluidleitungselements vorbereitet sein. Beispielsweise kann der Querschnitt der Rinne ein Halbkreis mit einem Radius R sein, wobei R zumindest dem Querschnittsdurchmesser des Fluidleitungselements entspricht.

Der Schenkel kann eine Fläche zur Anlage des Wärmeleitelements an eine zu temperierende Fläche eines Photovoltaikmoduls sein. Zudem kann der Schenkel dazu vorbereitet sein, zumindest einen Teil einer Kollektorfläche eines Solarthermiemoduls bzw. eines Sonnenkollektors zu bilden. Vorzugsweise weist der Schenkel im Profilquerschnitt eine Länge L auf, die zumindest das 1-fache des Radius R der Rinne beträgt. Um eine besonders vorteilhafte Anlage des Wärmeleitelements mit dem Solarmodul zu ermöglichen, kann der Schenkel eine Länge L aufweisen, die zumindest das 2-fache der Breite der Rinne beträgt. Zweckmäßigerweise weist das Wärmeleitelement jeweils einen Schenkel zu beiden Seiten der Rinne auf.

In einer weiteren Ausführungsform weist der Verbundwerkstoff Aluminium auf. Aluminium ist kostengünstig, ist gut zu verarbeiten und hat eine hohe thermische Leitfähigkeit. Weiter ist es vorteilhaft, wenn der Verbundwerkstoff, insbesondere überwiegend aus einer Vielzahl von ungeordnet liegenden Teilchen gebildet ist. Besonders geeignet sind Späne und/oder ein Granulat. Eine gute Verarbeitbarkeit verbunden mit einer hohen mechanischen Stabilität kann erreicht werden, wenn die Teilchen eine mittlere größte Ausdehnung zwischen 0,5 mm und 10 mm aufweisen. Um eine besonders gute formgebende Verarbeitbarkeit des Verbundwerkstoffs zu einem Wärmeleitelement zu erreichen, weisen die Teilchen eine mittlere maximale Länge zwischen 3 mm und 6 mm auf. Um Rohstoffkosten zu reduzieren, können die Metallteilchen ein Recyclingmaterial sein, welches beispielsweise bei einer spanenden Metallbearbeitung anfällt, und eine Komponente des Verbundwerkstoffs bilden.

In einer vorteilhaften Weiterbildung der Erfindung weist der Verbundwerkstoff ein Alkalisilikat, insbesondere Na₂SiO₃ und/oder K₂SiO₃, auf. Durch die Verwendung eines Alkalisilikats als Bindemittel kann eine chemische Bindung mit einem Oberflächenmaterial eines Bindungspartners, beispielsweise einer metallhaltigen Komponente des Verbundwerkstoffs, hergestellt und damit eine haftfeste Verklebung der Komponenten des Verbundwerkstoffs erreicht werden.

In einer weiteren vorteilhaften Ausgestaltung weist der Verbundwerkstoff eine feuerhemmende Substanz auf. Besonders vorteilhaft ist ein Borsalz, ein Aluminiumsilikat, ein Aluminiumhydroxid, ein Phospat, ein Gips und/oder ein Zement. Hierdurch kann ein Einsatzbereich des Verbundwerkstoffs bzw. des Wärmeleitelements in hohen Temperaturen erreicht werden.

In der Erprobung hat sich gezeigt, dass es vorteilhaft ist, wenn der Verbundwerkstoff cellulosehaltige Fasern aufweist. Besonders vorteilhaft haben die Fasern einemittlere Länge von 200 µm bis 3000 µm. Cellulosehaltige Fasern, beispielsweise aus Altpapier, sind preiswert und einfach verfügbar, wodurch erhöhte Herstellungskosten für den Verbundwerkstoff vermieden werden. Ferner können cellulosehaltige Fasern in einer Vielzahl von unterschiedlichen Längen im Handel bezogen werden.

Weist der Verbundwerkstoff cellulosehaltige Fasern mit einer mittleren Länge zwischen 200 µm und 500 µm auf, kann eine gute Verarbeitbarkeit erreicht werden. Für einen mechanisch stabilen und dennoch gut zu verarbeitenden Verbundwerkstoll ist eine mittlere Faserlänge der cellulosehaltigen Fasern zwischen 500 µm und 1500 µm vorteilhaft. Um beispielsweise eine besonders gute Verkettung mit weiteren Bestandteilen des Verbundwerkstoffs zu erzielen, kann die mittlere Länge der cellulosehaltigen Fasern zwischen 1500 µm und 3000 µm liegen.

In einer weiteren vorteilhaften Ausführungsform weist der Verbundwerkstoff Aluminium auf und der Massenanteil der cellulosehaltigen Fasern beträgt 5 % bis 20 % des Massenanteils des Aluminiums. Die Duktilität des Wärmeleitelements kann auf besonders einfache Weise durch den Massenanteil der cellulosehaltigen Fasern beeinflusst werden. Außerdem kann der Wärmeausdehnungskoeffizient des Wärmeleitelements durch eine entsprechende Veränderung des Anteils der cellulosehaltigen Fasern im Verbundwerkstoff beeinflusst werden.

Um eine hohe Duktilität zu erreichen, kann der Massenanteil der cellulosehaltigen Fasern zwischen 15 % und 20 % des Massenanteils des Aluminiums betragen. Eine besonders hohe Wärmeleitfähigkeit des Wärmeleitelements kann erreicht werden, wenn der Massenanteil der cellulosehaltigen Fasern von 5 % bis 10 % des Massenanteils des Aluminiums beträgt. Ein hinreichend duktiles und hinreichend wärmeleitfähiges Wärmeleitelement kann erreicht werden, wenn der Verbundwerkstoff cellulosehaltige Fasern mit einem Massenanteil von 10 % bis 15 % des Massenanteils des Aluminiums aufweist.

Es ist vorteilhaft, wenn die Wärme leitende Füll- und/oder Klebemasse ein Graphitpulver als eine Wärme leitende Substanz und ein Alkalisilikat, insbesondere Na₂SiO₃ oder K₂SiO₃, aufweist. Das Graphitpulver kann aus geblähtem oder ungeblähtem Graphit hergestellt sein und eine mittlere Korngröße zwischen insbesondere 5 µm und 300 µm aufweisen. Durch das Graphitpulver kann eine besonders hohe Wärmeleitfähigkeit der Füll- und/oder Klebemasse erreicht werden. Zudem kann durch eine Anpassung des Graphitgehalts der Füll- und/oder Klebemasse eine Angleichung der Wärmleitfähigkeit der Füll- und/oder Klebemasse an die Wärmeleitfähigkeit des Wärmeleitelements vorgenommen werden. Auf diese Weise kann ein vorteilhafter Wärmetransport unter Vermeidung von Temperaturgradienten zwischen der Füll- und/oder Klebemasse und dem Wärmeleitelement erreicht werden.

Die Füll- und/oder Klebemasse ist vorteilhafterweise temperaturbeständig bis zumindest 150 °C, insbesondere bis zumindest 300 °C, bevorzugt bis zumindest 500 °C. Temperaturbeständig bedeutet in diesem Zusammenhang, dass eine Haft- bzw. eine Klebewirkung und/oder eine Festigkeit der Füll- und/oder Klebemasse bis zur angegebenen Temperatur nicht wesentlich vermindert wird.

Durch die Verwendung eines Alkalisilikats als ein Bindemittel der Füll- und/oder Klebemasse kann infolge eines chemischen Bindungsmechanismus eine vorteilhafte, insbesondere haftfeste, Verklebung der Füll- und/oder Klebemasse mit metallhaltigen Komponenten der Solarmodultemperieranordnung, insbesondere mit dem Fluidleitungselement und/oder dem Wärmeleitelement, erreicht werden.

Zweckmäßigerweise weist das Wärmeleitelement eine geschwärzte Oberfläche zur Verstärkung einer Strahlungsabsorption auf. Die geschwärzte Oberfläche kann durch eine sogenannte selektive Solarbeschichtung gebildet sein. Durch die geschwärzte Oberfläche kann auf einfache Weise die Strahlungsabsorption des Wärmeleitelements, insbesondere wenn es als Teil einer Kollektorfläche eines Solarthermiemoduls angeordnet ist, erhöht werden. Ferner kann eine ungewollte Abstrahlung vermindert und dadurch ein ungewollter Wärmeverlust verringert werden.

In einer weiteren vorteilhaften Ausgestaltung ist das Wärmeleitelement zur Sonnenseite eines Modulgehäuses ausgerichtet. Durch die derartige Anordnung kann das Wärmeleitelement zumindest einen Teil einer Kollektorfläche für ein Solarthermiemodul bilden. Zweckmäßigerweise sind mehrere Wärmeleitelemente zum erreichen einer hinreichend großen Kollektorfläche nebeneinander angeordnet.

Zudem ist er vorteilhaft, wenn das Wärmeleitelement von einer Glasabdeckplatte abgedeckt ist, wobei zwischen dem Wärmeleitelement und der Glasplatte eine Luftschicht liegt. Durch die Luftschicht zwischen dem Wärmeleitelement und der Glasplatte kann auf einfache Weise eine thermische Isolation des Wärmeleitelements zur Vermeidung ungewollter Wärmeverluste erreicht werden. Zweckmäßigerweise vermindert die Glasplatte einen den ungewollten Wärmeverlust begünstigenden Austausch der Luftschicht. Zudem kann durch die Glasplatte eine ungewollte Abstrahlung von Wärmeenergie vermindert werden.

In einer weiteren Ausführungsform ist das Wärmeleitelement mit einer zu temperierenden Oberfläche eines Photovoltaikmoduls verbunden. Durch die derartige Anordnung kann das Wärmeleitelement zur Temperierung, insbesondere zur Kühlung, des Photovoltaikmoduls vorbereitet sein. Das Wärmeleitelement kann bevorzugt auf einer der Sonne abgewandten Oberfläche einer Solarzelle angeordnet sein. Die Verbindung zwischen dem Wärmeleitelement und der zu temperierenden Oberfläche des Photovoltaikmoduls bzw. der Solarzelle kann vorteilhafterweise mittels der Wärme leitenden Füll- und/oder Klebemasse hergestellt sein.

Das Wärmeleitelement und das Fluidleitungselement sind Bestandteil der Solarmodultemperieranordnung zur Temperierung eines Solarmoduls. Es ist jedoch ebenso gut möglich, eine andere Einheit zu temperieren, wie eine Fußboden, eine Fassade, ein Gehäusebauteil, eine Verpackung, eine Fahrzeugbaueinheit und/oder dergleichen. Insofern ist die Erfindung auch ganz allgemein gerichtet auf eine Temperieranordnung zur Temperierung einer Baueinheit, so dass ein solarer Bezug nicht zwingend ist und im Vorhergehenden und Folgenden der Begriff Solarmodultemperieranordnung durch Temperieranordnung und der Begriff Solarmodul durch Baueinheit ersetzt werden können.

Außerdem ist die Erfindung gerichtet auf ein Verfahren zur Herstellung einer Solarmodultemperieranordnung mit einem Wärmeleitelement und einem Fluidleitungselement.

Erfindungsgemäß wird das Wärmeleitelement aus einem Verbundwerkstoff geformt, mit dem Fluidleitungselement mittels einer Füll- und/oder Klebemasse verklebt und in einem Solarmodul angeordnet.

Das Wärmeleitelement kann bevorzugt als Profilbauteil, insbesondere durch einen Pressvorgang oder eine Extrusion oder dergleichen, geformt werden. Das Fluidleitungselement kann ein Rohr oder ein Schlauch oder dergleichen sein. Die Füll- und/oder Klebemasse ist bevorzugt eine Kompositmasse, die zumindest einen Füllstoff und ein Bindemittel aufweist. Die Füll- und/oder Klebemasse ist insbesondere ein aushärtender Kleber, der vorteilhafterweise bis zumindest 250° C temperaturbeständig ist. Weiter ist eine Wärmeleitung von zumindest 30 %, insbesondere zumindest 50 % von Aluminium vorteilhaft.

Wie beschrieben, kann zunächst das Wärmeleitelement mit dem Fluidleitungselement verklebt und hiernach in dem Solarmodul angeordnet werden. Es ist möglich, dass zunächst das Fluidleitungselement im bzw. am Solarmodul angeordnet wird und dann mit dem Wärmeleitelement verklebt wird. Selbstverständlich kann zunächst das Wärmeleitelement im bzw. am Solarmodul angeordnet und dann mit dem Fluidleitungselement verklebt wird.

In einer vorteilhaften Ausführungsform der Erfindung wird das Fluidleitungselement auf einer zu temperierenden Oberfläche eines Photovoltaikmoduls angeordnet. Die zu temperierende Oberfläche kann eine Oberfläche, insbesondere auf einer der Sonne abgewandten Seite, einer Solarzelle sein.

Vorteilhafterweise wird die Füll- und/oder Klebemasse in eine Aufnahmevertiefung des Wärmeleitelements eingebracht. Die Füll- und/oder Klebemasse wird zweckmäßigerweise in einem pastösen und/oder einem viskosen oder einem flüssigen Zustand in die Aufnahmevertiefung eingebracht. Es ist zweckmäßig, die Aufnahmevertiefung zumindest in einem überwiegenden Teil ihrer Länge mit der Füll- und/oder Klebemasse zu befüllen. Vorteilhafterweise kann die Füll- und/oder Klebemasse auch auf einen an die Aufnahmevertiefung angrenzenden Bereich des Wärmeleitelements, beispielsweise einen Schenkel, eine Anlagefläche oder dergleichen, aufgebracht werden.

Weiter ist es vorteilhaft, wenn die mit der Füll- und/oder Klebemasse versehene Aufnahmevertiefung des Wärmeleitelements auf das Fluidleitungselement und einen angrenzenden Bereich der zu temperierenden Oberfläche gedrückt wird. Hierdurch kann eine Klebeverbindung zwischen dem Fluidleitungselement und dem Wärmeleitelement und dem Wärmeleitelement und der zu temperierenden Oberfläche in einfacher Weise hergestellt werden, so dass eine Montage einfach ist.

Die oben genannten einzelnen Schritte des Verfahrens sind in einer dem Fachmann naheliegenden Weise zu mehreren äquivalenten Verfahren mit verschiedenartigen Schrittabfolgen kombinierbar.

Zweckmäßigerweise werden mehrere Fluidleitungselemente auf der zu temperierenden Oberfläche nebeneinander angeordnet und jeweils durch ein Aufdrücken jeweils eines mit der Füll- und/oder Klebemasse versehenen Wärmeleitelements mit der zu temperierenden Oberfläche verklebt. Vorzugweise werden die Fluidleitungselemente parallel nebeneinander angeordnet.

Vorteilhafterweise werden die Fluidleitungselemente durch Verbindungsleitungen verbunden. Die Verbindungsleitungen können flexible Schläuche, oder starre Röhren sein, die jeweils einen an die Abstände der Fluidleitungselemente angepassten Biegeradius aufweisen. Zweckmäßigerweise wird durch die Verbindung der Fluidleitungselemente mit dem Verbindungselementen eine zusammenhängende mäanderförmig verlaufende Fluidleitung hergestellt. Durch eine andere Anordnung der Fluidleitungselemente auf der zu temperierenden Oberfläche und eine andere Führung der Verbindungsleitungen kann auch eine als eine sogenannte Harfe ausgebildete Fluidleitung erreicht werden.

Durch die Beschriebene Anordnung der Wärmeleitelemente, der Fluidleitungselemente und deren Verbindung mit der Füll- und/oder Klebemasse kann auf einfache Weise eine vorteilhafte Solarmodultemperieranordnung, insbesondere für ein Photovoltaikmodul, erreicht werden.

In einer weiteren vorteilhaften Ausführungsform wird die Füll- und/oder Klebemasse in eine Aufnahmevertiefung des Wärmeleitelements eingebracht und das Fluidleitungselement wird in die mit der Füll- und/oder Klebemasse versehene Aufnahmevertiefung eingepresst und insbesondere mit Füll- und/oder Klebemasse bedeckt.

Zweckmäßigerweise wird eine Klebeverbindung zwischen dem Wärmeleitelement und dem Fluidleitungselement hergestellt. Vorteilhafterweise wird die Klebeverbindung durch die Füll- und/oder Klebemasse, bzw. ein Bindemittel der Füll- und/oder Klebemasse, hergestellt.

Insbesondere bei einer Verwendung in einem Thermosolarmodul ist es von Vorteil, wenn das mit dem Fluidleitungselement und der Füll- und/oder Klebemasse versehene Wärmeleitelement derart in ein Modulgehäuse eingesetzt wird, dass das Wärmeleitelement zur Sonnenseite des Modulgehäuses ausgerichtet ist.

Das Modulgehäuse umgibt das Solarmodul zweckmäßigerweise zumindest überwiegend. Vorteilhafterweise deckt das Modulgehäuse das Solarmodul nach oben hin ab und schützt es so vor Witterungseinflüssen. Eine einfache Befestigung des Wärmeleitelements im Modulgehäuse kann erreicht werden, wenn es mit einem Profilende in eine für diesen Zweck vorbereitete Nut im Modulgehäuse eingesetzt wird. Alternativ oder zusätzlich kann das Wärmleitelement auf einen Rand des Modulgehäuses aufgelegt und insbesondere verbunden, beispielsweise mit einem Verbindungsmittel, wie eine Schraube, eine Niete oder dergleichen, werden.

Die oben genannten einzelnen Schritte des Verfahrens sind in einer dem Fachmann naheliegenden Weise zu mehreren äquivalenten Verfahren mit verschiedenartigen Schrittabfolgen kombinierbar.

Ferner ist es vorteilhaft, wenn mehrere jeweils mit einem Fluidleitungselement und Füll- und/oder Klebemasse versehene Wärmeleitelemente nebeneinander in das Modulgehäuse eingesetzt werden, zweckmäßigerweise parallel zueinander. Vorteilhafterweise werden die Fluidleitungselemente durch Verbindungsleitungen verbunden. Die Verbindungsleitungen können flexible Schläuche, oder starre Röhren sein, die jeweils einen an die Abstände der Fluidleitungselemente angepassten Biegeradius aufweisen. So kann beispielweise durch die Verbindung der Fluidleitungselemente mit den Verbindungselementen eine zusammenhängende, insbesondere mäanderförmig verlaufende, Fluidleitung hergestellt werden.

Durch die beschriebene Anordnung der Wärmeleitelemente, der Fluidleitungselemente und deren Verbindung mit der Füll- und/oder Klebemasse kann auf einfache Weise eine vorteilhafte Solarmodultemperieranordnung, insbesondere für ein Solarthermiemodul, erreicht werden. Auf diese Weise kann mit einfachen Mitteln eine Kollektorfläche mit integrierter Wärmeleit- und Wärmetransportfunktionalität hergestellt werden.

In einer weiteren vorteilhaften Ausführungsform weist der Verbundwerkstoff Aluminium in Form von Teilchen auf. Das Aluminium kann in Form eines Granulats, von Spänen, eines Pulvers oder dergleichen für die Herstellung des Verbundwerkstoffs vorliegen. Um Rohstoffkosten zu reduzieren, ist es besonders vorteilhaft Metallspäne als ein Recyclingmaterial zu verwenden. Um eine gute Verarbeitbarkeit bzw. Mischbarkeit des Verbundwerkstoffs zu erreichen, empfiehlt es sich, Späne mit einer Länge von 1 mm bis 3 mm zu verwenden. Um eine besonders gute Verkettung bzw. ein Verkrallen der Späne im Verbundwerkstoff zu erreichen, können Späne mit einer Länge von 4 mm bis 8 mm, verwendet werden.

Ferner hat es sich in der Erprobung bewährt, wenn das Aluminium zur Ausbildung einer Oxidschicht auf zumindest 250°C erhitzt wird. Vorteilhafterweise wird das Aluminium in einem Ofen erhitzt. Hierbei kann die Ofenatmosphäre so eingestellt sein, dass während des Erhitzens eine besonders stark oxidierende Wirkung erreicht wird, beispielsweise durch eine Einleitung von Wasserdampf in den Ofen oder dergleichen. Ferner können durch das Erhitzen Schmutzrückstände von der Aluminiumoberfläche zumindest teilweise beseitigt werden. Dies gilt umso mehr, wenn vorteilhafterweise Aluminiumspäne als Recyclingmaterial verwendet werden, die üblicherweise mit Ölrückständen verunreinigt sind.

Durch die derart hergestellte Oxidschicht können insbesondere bei einer Verwendung von einem alkalisilikathaltigen Bindemittel - als ein Bestandteil des Verbundwerkstoffs und/oder als ein Bestandteil der Füll- und/oder Klebemasse- besonders hohe Haftkräfte erreicht werden. Diese besonders hohen Haftkräfte entstehen durch eine chemische AlSi-Verbindung zwischen dem Alkalisilikat und der derart hergestellten Oxidschicht und führen zu einer besonders festen Bindung innerhalb des Verbundwerkstoffs.

Des Weiteren ist es vorteilhaft, wenn eine Mischsuspension aus dem Aluminium, Wasser und/oder einem Bindemittel hergestellt wird. Zweckmäßigerweise wird ein Bindemittel verwendet, das ein Alkalisilikat aufweist. Die Mischsuspension kann in eine Pressform eingebracht werden. Die Pressform kann durch einen Gieß- oder Schüttvorgang befüllt werden.

Zweckmäßigerweise wird die Mischsuspension gepresst. Durch die Höhe des Pressdrucks kann die Wärmeleitfähigkeit des Verbundwerkstoffs beeinflusst werden. Dabei hat sich in der Erprobung gezeigt, dass je höher der Pressdruck ist, desto besser ist der Kontakt zwischen den Komponenten des Verbundwerkstoffs, desto weniger Lufteinschlüsse innerhalb des Verbundwerkstoffs, desto höher die Wärmleitfähigkeit.

Weiter ist es vorteilhaft, wenn die Mischsuspension entwässert wird, zweckmäßigerweise unter Pressdruck. Eine weitere Trocknung des Pressprodukts bzw. Formteils, z.B. an Luft, ist ebenfalls vorteilhaft.

In einer weiteren Ausführungsform wird die Mischsuspension unter Zugabe von cellulosehaltigen Fasern hergestellt. Hierbei ist es vorteilhaft, wenn cellulosehaltigen Fasern mit einer Länge von 200 µm bis 3000 µm und bis zu einem Massenanteil von 20 % des Massenanteils des Aluminiums in die Mischsuspension zugegeben werden. Durch die Zugabe eines angepassten Massenanteils der cellulosehaltigen Fasern kann die Duktilität des Verbundwerkstoffs beeinflusst, insbesondere erhöht, werden.

In einer vorteilhaften Ausgestaltung wird das Pressprodukt bei einer Temperatur von 400° C bis 650° C für eine Zeitdauer von zumindest 10 min getempert. Das Tempern kann vor und/oder nach der Trocknung des Pressprodukts erfolgen. Durch die derartige Wärmebehandlung können Ausdünstungen während eines späteren betriebsbedingten Erhitzens des Verbundwerkstoffs vermindert werden. Von besonderem Vorteil kann durch das Tempern im Verbundwerkstoffs befindliches Wasser - sei es in gebundener und/oder ungebundener Form - ausgetrieben werden. Dies gilt insbesondere für in AlSi-Bindungen des Verbundwerkstoffs gebundenes Wasser. Auf diese Weise kann eine besondere Wasser- bzw. Witterungsbeständigkeit des Verbundwerkstoffs erreicht werden.

Die bisher gegebene Beschreibung vorteilhafter Ausgestaltungen der Erfindung enthält zahlreiche Merkmale, die in den einzelnen Unteransprüchen teilweise zu mehreren zusammengefasst wiedergegeben sind. Diese Merkmale können jedoch zweckmäßigerweise auch einzeln betrachtet und zu sinnvollen weiteren Kombinationen zusammenfasst werden. Insbesondere sind diese Merkmale jeweils einzeln und in beliebiger geeigneter Kombination mit dem erfindungsgemäßen Verfahren und der erfindungsgemäßen Vorrichtung gemäß den unabhängigen Ansprüchen kombinierbar.

Die oben beschriebenen Eigenschaften, Merkmale und Vorteile dieser Erfindung, sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Die Ausführungsbeispiele dienen der Erläuterung der Erfindung und beschränken die Erfindung nicht auf die darin angegebene Kombination von Merkmalen, auch nicht in Bezug auf funktionale Merkmale. Außerdem können dazu geeignete Merkmale eines jeden Ausführungsbeispiels auch explizit isoliert betrachtet, aus einem Ausführungsbeispiel entfernt, in ein anderes Ausführungsbeispiel zu dessen Ergänzung eingebracht und/oder mit einem beliebigen der Ansprüche kombiniert werden.

Es zeigen:
- FIG 1: ein Modulgehäuse mit einer Solarmodultemperieranordnung in einer Schnittdarstellung und einer Detaildarstellung,
- FIG 2: ein Photovoltaikmodul mit einer Solarmodultemperieranordnung in einer Schnittdarstellung und einer Detaildarstellung,
- FIG 3: die Solarmodultemperieranordnung aus FIG 1 mit mäanderförmig verbundenen Fluidleitungselementen in einer Draufsicht,
- FIG 4: eine schematische Darstellung eines Verbundwerkstoffgefüges und
- FIG 5: ein Ablaufdiagramm eines Ausführungsbeispiels des erfindungsgemäßen Verfahrens.

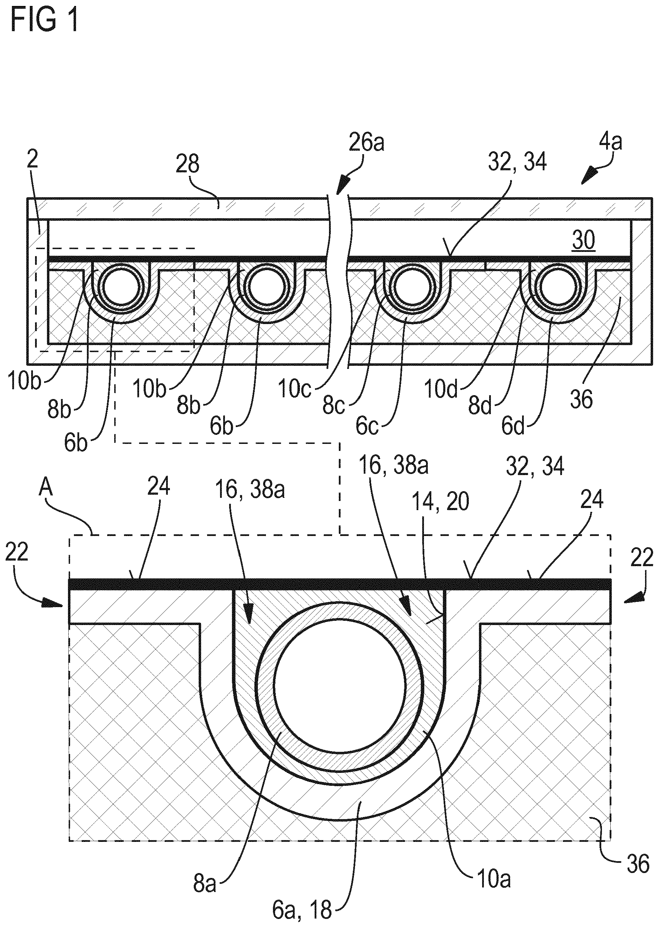

FIG 1 zeigt ein Solarmodul mit einem Modulgehäuse 2 und einer Solarmodultemperieranordnung 4a in einer Schnittdarstellung und einer Detaildarstellung A. Gleiche Bauteile, die jedoch geringfügige Unterschieden, z.B. in Abmessung, Position und/oder Funktion, aufweisen können, sind mit der gleichen Bezugsziffer und anderen Bezugsbuchstaben gekennzeichnet. Wird die Bezugsziffer alleine ohne einen Bezugsbuchstaben erwähnt, so sind die entsprechenden Bauteile aller Ausführungsbeispiele angesprochen.

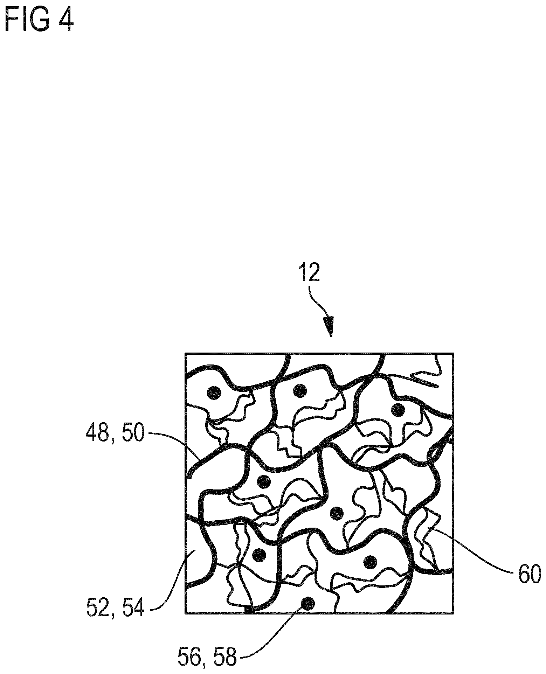

Wie in der Detaildarstellung A ersichtlich, weist die Solarmodultemperieranordnung 4a ein Wärmeleitelement 6a, ein Fluidleitungselement 8a und eine Wärme leitende Füll- und/oder Klebemasse 10a auf. Das Wärmeleitelement 6a besteht aus einem Verbundwerkstoff 12 (siehe FIG 4) und weist einen Aufnahmebereich 14 auf. Das Fluidleitungselement 8a ist im Aufnahmebereich 14 angeordnet und über die Füll- und/oder Klebemasse 10a mit dem Wärmeleitelement 6a verbunden. Die Füll- und/oder Klebemasse 10a füllt einen Radialspalt 16 zwischen dem Fluidleitungselement 8a und dem Aufnahmebereich 14 aus.

Im vorliegenden Ausführungsbeispiel ist das Wärmeleitelement 6a ein Profilbauteil 18 und der Aufnahmebereich 14 eine Rinne 20. Das Wärmeleitelement 6a weist zu beiden Seiten der Rinne 20 jeweils einen Schenkel 22 mit jeweils einer ebenen Anlagefläche 24 auf.

Die Solarmodultemperieranordnung 4a umfasst mehrere - jeweils gleichartige - Wärmeleitelemente 6a, 6b, 6c, 6d, mehrere Fluidleitungselemente 8a, 8b, 8c, 8d und mehrere Füll- und/oder Klebemassen 10a, 10b, 10c und 10d. Zur vereinfachten Darstellbarkeit weist die Darstellung eine Bruchkante 26a auf. Die Ausführung der Solarmodultemperieranordnung 4a ist deshalb selbstverständlich nicht auf die genannte Anzahl der gleichartigen Bauteile 6, 8 und 10 beschränkt.

Die Wärmeleitelemente 6 sind zur Sonnenseite des Modulgehäuses 2 ausgerichtet und von einer Glasabdeckplatte 28 abgedeckt. Zwischen den Wärmeleitelementen 6 und der Glasplatte 28 liegt eine Luftschicht 30. Die Wärmeleitelemente 6 weisen eine geschwärzte Oberfläche 32 - die eine optische selektive Oberfläche sein kann - zur Verstärkung einer Strahlungsabsorption auf. Die geschwärzte Oberfläche 32 erstreckt sich jeweils über die Schenkel 22 der Wärmeleitelemente 6 und die Oberflächen der Füll- und/oder Klebemassen 10 und bildet eine durchgehende Schicht bzw. eine Kollektorfläche 34. Auf diese Weise kann die Kollektorfläche 34 durch eine einfache parallele Anordnung der Wärmeleitelemente 6 gebildet werden, ohne dass eine separate Oberflächenbeschichtung aufgebracht werden muss. Dies ermöglicht es einen extrem einfachen Solarabsorber aufzubauen.

Zwischen der Rückseite der Kollektorfläche 34 und dem Modulgehäuse 2 bzw. zwischen der Rückseite der Wärmeleitelemente 6 und dem Modulgehäuse 2 ist ein Isolationsmaterial 36 angeordnet.

Zur Herstellung der Solarmodultemperieranordnung 4a wird die Füll- und/oder Klebemasse 10a in die Aufnahmevertiefung 14 bzw. die Rinne 20 des Wärmeleitelements 6a eingebracht. Das Fluidleitungselement 8a wird in die mit der Füll- und/oder Klebemasse 10a versehene Rinne 20 eingepresst. Dabei wird die Füll- und/oder Klebemasse 10a zu einem Teil aus der Rinne 20 verdrängt bzw. aus der Rinne 20 herausgequetscht. Das Fluidleitungselement 8a wird mit dem aus der Rinne 20 gedrängten Teil der Füll- und/oder Klebemasse 10a bedeckt, wobei eine Klebeverbindung 38a zwischen dem Wärmeleitelement 6a und dem Fluidleitungselement 8a hergestellt wird. Das derart mit dem Fluidleitungselement 8a und der Füll- und/oder Klebemasse 10a versehene Wärmeleitelement 6a wird in das Modulgehäuse 2 eingesetzt und zur Sonnenseite des Modulgehäuses 2 ausgerichtet.

Die genannten Schritte werden analog mit den Wärmeleitelementen 6b, 6c, 6d und gegebenenfalls weiteren Wärmeleitelementen und den Fluidleitungselemente 8b, 8c, 8d und gegebenenfalls weiteren Fluidleitungselementen durchgeführt.

Da die Solarmodultemperieranordnung 4a in oder an einem Solarmodul angeordnet ist, kann sie im gezeigten Ausführungsbeispiel als Solarmodultemperieranordnung 4a bezeichnet werden. Die Temperieranordnung 4a an sich kann jedoch auch Teil einer anderen Einheit sein, so dass sie dann eine Temperieranordnung 4a zum Temperieren dieser anderen Einheit bzw. eines Moduls, einer Platte oder einer Fläche dieser anderen Einheit ist. So kann beispielsweise anstelle der Kollektorfläche 34 eine Wandfläche, eine Fußbodenfläche, Deckenfläche, Fassadenfläche, Dachfläche, Gehäusefläche, eine Fläche einer Baueinheit eines Fahrzeugs, einer Verpackungseinheit, einer Arbeitsmaschine oder dergleichen temperiert werden. Gleiches gilt auch für die folgenden Ausführungsbeispiele.

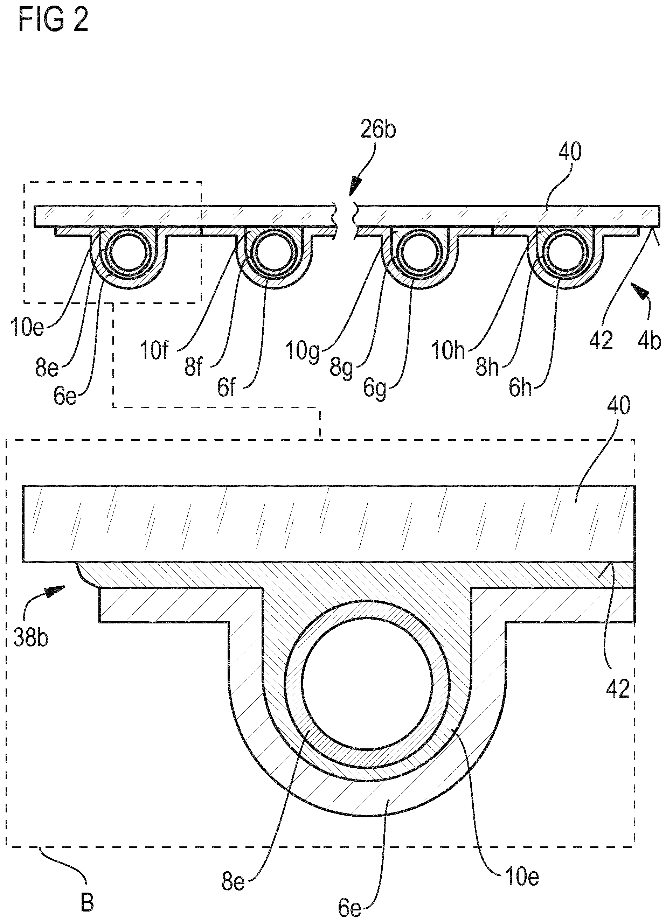

FIG 2 zeigt ein Photovoltaikmodul 40 mit einer Solarmodultemperieranordnung 4b in einer Schnittdarstellung und einer Detaildarstellung B. Die Solarmodultemperieranordnung 4b ist auf einer zu temperierenden Oberfläche 42 des Photovoltaikmoduls 40 angeordnet. Die nachfolgenden Beschreibungen beschränken sich im Wesentlichen auf die Unterschiede zu den vorhergehenden Ausführungsbeispielen, auf die bezüglich gleich bleibender Merkmale und Funktionen verwiesen wird. Im Wesentlichen gleich bleibende Bauteile sind grundsätzlich mit der gleichen Bezugsziffer gekennzeichnet und nicht erwähnte Merkmale sind in den folgenden Ausführungsbeispielen übernommen, ohne dass sie erneut beschrieben sind.

Wie in der Detaildarstellung B ersichtlich, weist die Solarmodultemperieranordnung 4b ein Wärmeleitelement 6e, ein Fluidleitungselement 8e und eine Wärme leitende Füll- und/oder Klebemasse 10e auf, wobei zur Erläuterung weiterer Details bzw. Merkmale der Anordnung aus die Ausführungen zu FIG 1 verwiesen wird. Ferner bildet die Füll- und/oder Klebemasse 10e eine Klebeverbindung 38b zur zu temperierenden Oberfläche 42 des Photovoltaikmoduls 40.

Die Solarmodultemperieranordnung 4b umfasst - ähnlich zur in FIG 1 dargestellten Solarmodultemperieranordnung 4a - mehrere, jeweils gleichartige Wärmeleitelemente 6e, 6f, 6g, 6h, mehrere Fluidleitungselemente 8e, 8f, 8g, 8h und mehrere Füll- und/oder Klebemassen 10e, 10f, 10g und 10h. Zur vereinfachten Darstellbarkeit weist die Darstellung eine Bruchkante 26b auf. Die Ausführung der Solarmodultemperieranordnung 4b ist deshalb selbstverständlich nicht auf die genannte Anzahl der gleichartigen Bauteile 6, 8 und 10 beschränkt.

Zur Herstellung der Solarmodultemperieranordnung 4b wird das Fluidleitungselement 6e auf der zu temperierenden Oberfläche 42 des Photovoltaikmoduls 40 angeordnet. Die Füll- und/oder Klebemasse 10e wird in die Aufnahmevertiefung 14 des Wärmeleitelements 6e eingebracht. Die mit der Füll- und/oder Klebemasse 10e versehene Aufnahmevertiefung 14 des Wärmeleitelements 6e wird auf das Fluidleitungselement 8e und einen angrenzenden Bereich der zu temperierenden Oberfläche 42 gedrückt, wodurch die Klebeverbindung 38b zwischen dem Fluidleitungselement 8e und dem Wärmeleitelement 6e und dem Wärmeleitelement 6e und der zu temperierenden Oberfläche 42 des Photovoltaikmoduls 40 hergestellt wird.

Die genannten Schritte werden mit den Wärmeleitelementen 6f, 6g, 6h und gegebenenfalls weiteren Wärmeleitelementen und den Fluidleitungselemente 8f, 8g, 8h und gegebenenfalls weiteren Fluidleitungselementen wiederholt.

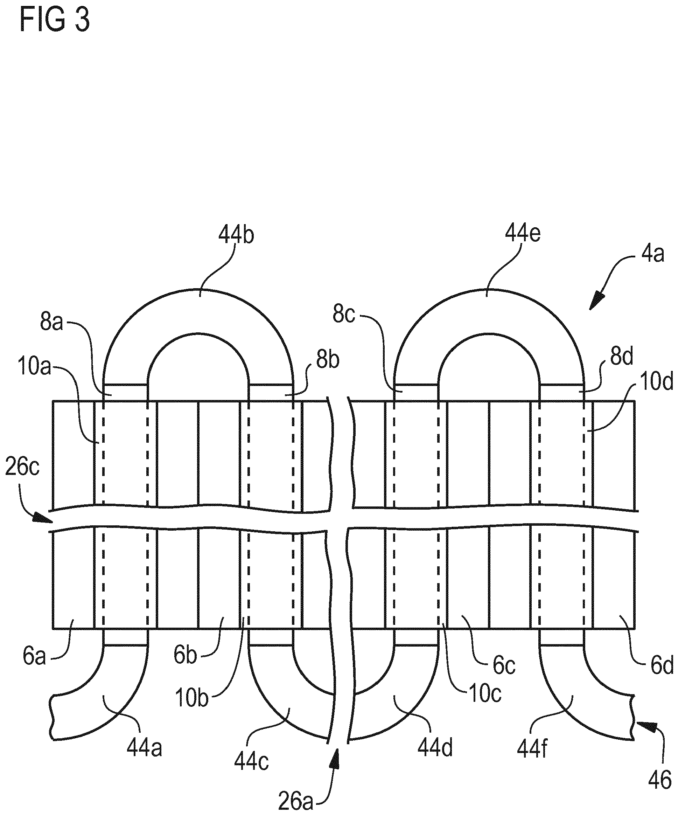

FIG 3 zeigt die Solarmodultemperieranordnung 4a aus FIG 1 mit verbundenen Fluidleitungselementen 8a, 8b, 8c und 8d in einer Draufsicht. Die Fluidleitungselemente 8 sind über mehrere Verbindungsleitungen 44 miteinander verbunden, so dass eine durchgehende mäanderförmige Fluidleitung 46 gebildet wird. Zur vereinfachten Darstellbarkeit weist die Darstellung die Bruchkanten 26a, 26c auf. Selbstverständlich ist auch möglich eine Fluidleitung in einer sogenannten Harfenform oder dergleichen auszuführen.

FIG 4 zeigt eine schematische Darstellung des Gefüges des Verbundwerkstoffs 12, aus welchem die Wärmeleitelemente 6a-d und 6e-h der Solarmodultemperieranordnung 4a aus FIG 1 und FIG 3 bzw. die Solarmodultemperieranordnung 4b aus FIG 2 bestehen. Aus Gründen der besseren Darstellbarkeit sind in FIG 4 teilweise lediglich einzelne Zeichnungselemente mehrerer gleichartiger Zeichnungselemente mit einem Bezugszeichen gekennzeichnet. Nicht mit einem Bezugzeichen gekennzeichnete Zeichnungselemente aus einer Gruppe mehrerer gleichartiger Zeichnungselemente weisen dabei selbstverständlich das Merkmal auf, welches dem gekennzeichneten Zeichnungselement der Gruppe durch ein Bezugszeichen zugewiesen wird.

Der Verbundwerkstoff 12 weist Aluminium 48 in Form von Spänen 50 auf. Im vorliegenden Ausführungsbeispiel weisen die Späne 50 eine Länge von 10 mm bis 15 mm auf. Außerdem weist der Verbundwerkstoff 12 ein Alkalisilikat 52 als Bindemittel 54 auf. Der Weiteren weist der Verbundwerkstoff 12 eine Substanz 56, hier im Speziellen ein Gips 58, auf. Insbesondere kann die Substanz 56 feuerhemmend sein. Ferner weist der Verbundwerkstoff 12 cellulosehaltige Fasern 60 auf. Die cellulosehaltige Fasern 60 weisen eine Länge von 100 µm bis 200 µm auf.

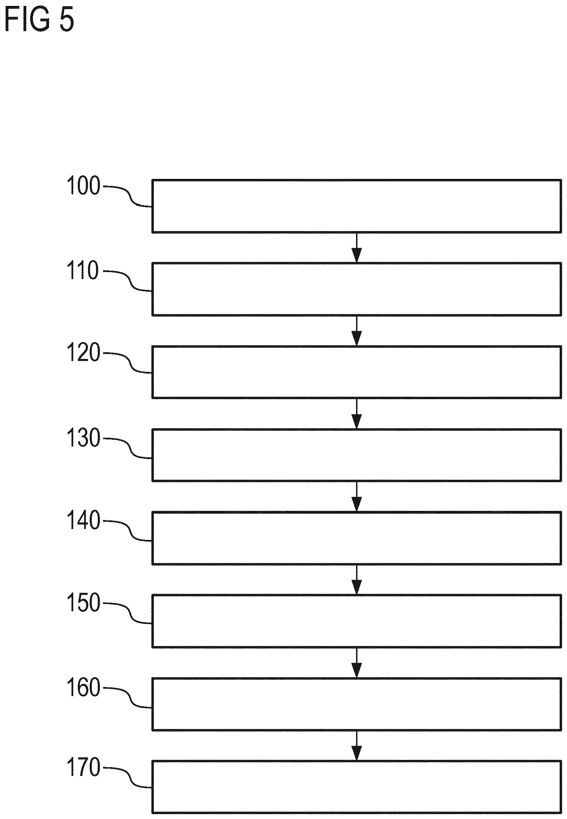

Die Herstellung des Verbundwerkstoffs 12 wird in FIG 5 in einer Prinzipdarstellung illustriert. Zunächst wird das Aluminium 48 bzw. werden die Späne 50 zur Ausbildung einer Oxidschicht erhitzt 100. Beispielsweise werden die Späne für 30 min auf 250 °C erhitzt. Danach wird eine Mischsuspension aus dem derart wärmebehandelten Aluminium 48 bzw. den Spänen 50, Wasser und dem Bindemittel 54 hergestellt 110. Im vorliegenden Ausführungsbeispiel werden der Mischsuspension cellulosehaltigen Fasern 60 zugegeben 120. Die Mischsuspension wird in eine Pressform eingebracht 130, gepresst 140, insbesondere rollgepresst, und unter Pressdruck entwässert 150. Das Pressprodukt wird getrocknet 160 und bei einer Temperatur von 400°C bis 650°C für eine Zeitdauer von zumindest 10 min getempert 170, wobei das Tempern 170 alternativ oder zusätzlich auch vor dem Trocknen 160 erfolgen kann.

### Bezugszeichenliste

- 2: Modulgehäuse
- 4a, 4b: Solarmodultemperieranordnung
- 6a-h: Wärmeleitelement
- 8a-h: Fluidleitungselement
- 10a-h: Füll- und/oder Klebemasse
- 12: Verbundwerkstoff
- 14: Aufnahmebereich
- 16: Radialspalt
- 18: Profilbauteil
- 20: Rinne
- 22: Schenkel
- 24: Anlagefläche
- 26a-c: Bruchkante
- 28: Glasabdeckplatte
- 30: Luftschicht
- 32: Oberfläche
- 34: Kollektorfläche
- 36: Isolationsmaterial
- 38a, 38b: Klebeverbindung
- 40: Photovoltaikmodul
- 42: Oberfläche
- 44a-f: Verbindungsleitung
- 46: Fluidleitung
- 48: Aluminium
- 50: Späne
- 52: Alkalisilikat
- 54: Bindemittel
- 56: feuerhemmende Substanz
- 58: Gips
- 60: cellulosehaltige Fasern
- 100: Erhitzen des Aluminiums
- 110: Herstellen der Mischsuspension
- 120: Hinzugeben der cellulosehaltigen Fasern
- 130: Einbringen in Pressform
- 140: Pressen
- 150: Entwässern unter Pressdruck
- 160: Trocknen des Pressprodukts
- 170: Tempern des Pressprodukts
- A, B: Detaildarstellung

## Patentansprüche

1. Solarmodultemperieranordnung (4a, 4b) mit einem Wärmeleitelement (6a-h), einem Fluidleitungselement (8a-h) und einer Wärme leitenden Füll- und/oder Klebemasse (10a-h),
**dadurch gekennzeichnet,**
**dass** das Wärmeleitelement (6a-h) aus einem Verbundwerkstoff (12) besteht und einen Aufnahmebereich (14) aufweist, das Fluidleitungselement (8a-h) in seiner Längsrichtung zumindest abschnittsweise am Aufnahmebereich (14) angeordnet und über die Füll- und/oder Klebemasse (10a-h) mit dem Wärmeleitelement (6a-h) verbunden ist, wobei die Füll- und/oder Klebemasse (10a-h) einen Radialspalt (16) zwischen dem Fluidleitungselement (8a-h) und dem Aufnahmebereich (14) zumindest teilweise ausfüllt.

2. Solarmodultemperieranordnung (4a, 4b) nach Anspruch 1,
**dadurch gekennzeichnet,**
**dass** das Wärmeleitelement (6a-h) ein Profilbauteil (18) mit einer Rinne (2C) als Aufnahmebereich (14) ist und zu zumindest einer Seite der Rinne (20) einen Schenkel (22) mit einer zumindest abschnittsweise ebenen Anlagefläche (24) aufweist.

3. Solarmodultemperieranordnung (4a, 4b) nach Anspruch 1 oder 2,
**dadurch gekennzeichnet,**
**dass** der Verbundwerkstoff (12) ein Alkalisilikat (52), insbesondere Na₂SiO₃ oder K₂SiO₃, aufweist.

4. Solarmodultemperieranordnung (4a, 4b) nach einem der vorhergehenden Ansprüche,
**dadurch gekennzeichnet,**
**dass** der Verbundwerkstoff (12) eine feuerhemmende Substanz (56), insbesondere ein Borsalz, ein Aluminiumsilikat, ein Aluminiumhydroxid, ein Phospat, ein Gips (58) und/oder ein Zement, aufweist.

5. Solarmodultemperieranordnung (4a, 4b) nach einem der vorhergehenden Ansprüche,
**dadurch gekennzeichnet,**
**dass** der Verbundwerkstoff (12) cellulosehaltige Fasern (60) mit einer Länge von 200 µm bis 3000 µm aufweist.

6. Solarmodultemperieranordnung (4a, 4b) nach Anspruch 6,
**dadurch gekennzeichnet,**
**dass** der Verbundwerkstoff (12) Aluminium (48) aufweist und der Massenanteil der cellulosehaltigen Fasern (60) 5 % bis 20 % des Massenanteils des Aluminiums (48) beträgt.

7. Solarmodultemperieranordnung (4a, 4b) nach einem der vorhergehenden Ansprüche,
**dadurch gekennzeichnet,**
**dass** die Wärme leitende Füll- und/oder Klebemasse (10a-h) ein Graphitpulver als eine Wärme leitende Substanz und ein Alkalisilikat, insbesondere Na₂SiO₃ oder K₂SiO₃, aufweist.

8. Solarmodultemperieranordnung (4a) nach einem der vorhergehenden Ansprüche,
**dadurch gekennzeichnet,**
**dass** das Wärmeleitelement (6a-d) eine geschwärzte Oberfläche (32) zur Verstärkung einer Strahlungsabsorption aufweist und zur Sonnenseite eines Modulgehäuses (2) ausgerichtet und von einer Glasabdeckplatte (28) abgedeckt ist, wobei zwischen dem Wärmeleitelement (6a-d) und der Glasplatte (28) eine Luftschicht (30) liegt.

9. Solarmodultemperieranordnung (4b) nach einem der vorhergehenden Ansprüche,
**dadurch gekennzeichnet,**
**dass** das Wärmeleitelement (6e-h) mit einer zu temperierenden Oberfläche (42) eines Photovoltaikmoduls (40) verbunden ist.

10. Verfahren zur Herstellung einer Solarmodultemperieranordnung (4a, 4b) mit einem Wärmeleitelement (6a-h) und einem Fluidleitungselement (8a-h),
**dadurch gekennzeichnet,**
**dass** das Wärmeleitelement (6a-h) aus einem Verbundwerkstoff (12) geformt, mit dem Fluidleitungselement (8a-h) mittels einer Füll- und/oder Klebemasse (10a-h) verklebt und in einem Solarmodul (2, 40) angeordnet wird.

11. Verfahren nach Anspruch 1C,
**dadurch gekennzeichnet,**
**dass** das Fluidleitungselement (8e-h) auf einer zu temperierenden Oberfläche (42) eines Photovoltaikmoduls (40) angeordnet wird, die Füll- und/oder Klebemasse (10e-h) in eine Aufnahmevertiefung (14) des Wärmeleitelements (6e-h) eingebracht wird, die mit der Füll- und/oder Klebemasse (10e-h) versehene Aufnahmevertiefung (14) des Wärmeleitelements (6e-h) auf das Fluidleitungselement (8e-h) und einen angrenzenden Bereich der zu temperierenden Oberfläche (42) gedrückt und dadurch eine Klebeverbindung (38b) zwischen dem Fluidleitungselement (8e-h) und dem Wärmeleitelement (6e-h) und dem Wärmeleitelement (6e-h) und der zu temperierenden Oberfläche (42) hergestellt wird.

12. Verfahren nach Anspruch 10 oder 11,
**dadurch gekennzeichnet,**
**dass** mehrere Fluidleitungselemente (8e-h) auf der zu temperierenden Oberfläche (42) nebeneinander angeordnet und jeweils durch ein Aufdrücken jeweils eines mit der Füll- und/oder Klebemasse (10e-h) versehenen Wärmeleitelements (6e-h) mit der zu temperierenden Oberfläche (42) verklebt werden, die Fluidleitungselemente (8e-h) durch Verbindungsleitungen (44a-f) verbunden und dadurch eine zusammenhängende, insbesondere mäanderförmig verlaufende, Fluidleitung (46) hergestellt wird.

13. Verfahren nach einem der Ansprüche 10 bis 12,
**dadurch gekennzeichnet**,
die Füll- und/oder Klebemasse (10a-d) in eine Aufnahmevertiefung (14) des Wärmeleitelenents (6a-d) eingebracht wird, das Fluidleitungselement (8a-d) in die mit der Füll- und/oder Klebemasse (10a-d) versehene Aufnahmevertiefung (14) eingepresst und mit Füll- und/oder Klebemasse (10a-d) bedeckt wird, wobei eine Klebeverbindung (38a) zwischen dem Wärmeleitelement (6a-d) und dem Fluidleitungselement (8a-d) hergestellt wird und das derart mit dem Fluidleitungselement (8a-d) und der Füll- und/oder Klebemasse (10a-d) versehene Wärmeleitelement (6a-d) derart in ein Modulgehäuse (2) eingesetzt wird, dass das Wärmeleitelement (6a-d) zur Sonnenseite des Modulgehäuses (2) ausgerichtet ist.

14. Verfahren nach einem der Ansprüche 10 bis 13,
**dadurch gekennzeichnet,**
**dass** der Verbundwerkstoff (12) Aluminium (48, 50) in Form von Teilchen aufweist, das zur Ausbildung einer Oxidschicht auf zumindest 250°C erhitzt (100) wird, eine Mischsuspension aus dem Aluminium (48, 50), Wasser und/oder einem Bindemittel (54) hergestellt (110) wird, die Mischsuspension in eine Pressform eingebracht (130), gepresst (140), vorzugsweise unter Pressdruck entwässert (150) und ein Pressprodukt getrocknet (160) wird.

15. Verfahren nach Anspruch 14,
**dadurch gekennzeichnet,**
**dass** das Pressprodukt bei einer Temperatur von 400° C bis 650° C für eine Zeitdauer von zumindest 10 min getempert (170) wird.

## Claims

1. Solar module temperature-control assembly (4a, 4b) having a heat-conducting element (6a-h), a fluid-conducting element (8a-h) and a heat-conducting filling and/or adhesive compound (10a-h),
**characterized in that**
the heat-conducting element (6a-h) consists of a composite material (12) and has a receiving region (14), the fluid-conducting element (8a-h) is at least in certain portions in its longitudinal direction arranged on the receiving region (14) and is connected to the heat-conducting element (6a-h) via the filling and/or adhesive compound (10a-h), wherein the filling and/or adhesive compound (10a-h) at least partially fills a radial gap (16) between the fluid-conducting element (8a-h) and the receiving region (14) .

2. Solar module temperature-control assembly (4a, 4b) according to Claim 1,
**characterized in that**
the heat-conducting element (6a-h) is a profiled component (18) with a channel (20) as a receiving region (14) and to at least one side of the channel (20) has a limb (22) with a contact surface (24) that is planar, at least in certain portions.

3. Solar module temperature-control assembly (4a, 4b) according to Claim 1 or 2,
**characterized in that**
the composite material (12) comprises an alkali silicate (52), in particular Na₂SiO₃ or K₂SiO₃.

4. Solar module temperature-control assembly (4a, 4b) according to one of the preceding claims,
**characterized in that**
the composite material (12) comprises a fire-retardant substance (56), in particular a boron salt, an aluminium silicate, an aluminium hydroxide, a phosphate, a gypsum (58) and/or a cement.

5. Solar module temperature-control assembly (4a, 4b) according to one of the preceding claims,
**characterized in that**
the composite material (12) comprises cellulosic fibres (60) with a length of 200 µm to 3000 µm.

6. Solar module temperature-control assembly (4a, 4b) according to Claim 5,
**characterized in that**
the composite material (12) comprises aluminium (48) and the proportion by mass of the cellulosic fibres (60) amounts to 5% to 20% of the proportion by mass of the aluminium (48).

7. Solar module temperature-control assembly (4a, 4b) according to one of the preceding claims,
**characterized in that**
the heat-conducting filling and/or adhesive compound (10a-h) comprises a graphite powder as a heat-conducting substance and an alkali silicate, in particular Na₂SiO₃ or K₂SiO₃.

8. Solar module temperature-control assembly (4a) according to one of the preceding claims,
**characterized in that**
the heat-conducting element (6a-d) has a blackened surface (32) for improving the radiation absorption and is oriented towards the sun side of a module housing (2) and is covered by a glass covering panel (28), wherein there is a layer of air (30) lies between the heat-conducting element (6a-d) and the glass panel (28).

9. Solar module temperature-control assembly (4b) according to one of the preceding claims,
**characterized in that**
the heat-conducting element (6e-h) is connected to a surface (42) to be temperature-controlled of a photovoltaic module (40).

10. Method for producing a solar module temperature-control assembly (4a, 4b) having a heat-conducting element (6a-h) and a fluid-conducting element (8a-h),
**characterized in that**
the heat-conducting element (6a-h) is formed from a composite material (12), adhesively bonded to the fluid-conducting element (8a-h) by means of a filling and/or adhesive compound (10a-h) and arranged in a solar module (2, 40) .

11. Method according to Claim 10,
**characterized in that**
the fluid-conducting element (8e-h) is arranged on a surface (42) to be temperature-controlled of a photovoltaic module (40), the filling and/or adhesive compound (10e-h) is introduced into a receiving depression (14) of the heat-conducting element (6e-h), the receiving depression (14) of the heat-conducting element (6e-h) that is provided with the filling and/or adhesive compound (10e-h) is pressed onto the fluid-conducting element (8e-h) and an adjacent region of the surface (42) to be temperature-controlled and as a result an adhesive connection (38b) is produced between the fluid-conducting element (8e-h) and the heat-conducting element (6e-h) and between the heat-conducting element (6e-h) and the surface (42) to be temperature-controlled.

12. Method according to Claim 10 or 11,
**characterized in that**
a plurality of fluid-conducting elements (8e-h) are arranged next to one another on the surface (42) to be temperature-controlled and are each adhesively bonded to the surface (42) to be temperature-controlled by in each case pressing on a heat-conducting element (6e-h) provided with the filling and/or adhesive compound (10e-h), the fluid-conducting elements (8e-h) are connected by connecting lines (44a-f) and as a result a fluid line (46) that is continuous, in particular follows a path of a meandering form, is produced.

13. Method according to one of Claims 10 to 12,
**characterized in that**
the filling and/or adhesive compound (10a-d) is introduced into a receiving depression (14) of the heat-conducting element (6a-d), the fluid-conducting element (8a-d) is pressed into the receiving depression (14) provided with the filling and/or adhesive compound (10a-d) and covered with filling and/or adhesive compound (10a-d), wherein an adhesive connection (38a) is produced between the heat-conducting element (6a-d) and the fluid-conducting element (8a-d) and the heat-conducting element (6a-d) provided in this way with the fluid-conducting element (8a-d) and the filling and/or adhesive compound (10a-d) is inserted into a module housing (2) in such a way that the heat-conducting element (6a-d) is oriented towards the sun side of the module housing (2) .

14. Method according to one of Claims 10 to 13,
**characterized in that**
the composite material (12) comprises aluminium (48, 50) in the form of particles that is heated (100) to at least 250 °C to form an oxide layer, a mixed suspension of the aluminium (48, 50), water and/or a binder (54) is produced (110), the mixed suspension is introduced (130) into a pressing mould, pressed (140), preferably dewatered (150) under the effect of pressing pressure and a pressed product is dried (160) .

15. Method according to Claim 14,
**characterized in that**
the pressed product is annealed (170) at a temperature of 400°C to 650°C for a time duration of at least 10 min.

## Revendications

1. Arrangement d'équilibrage de la température d'un module solaire (4a, 4b) comprenant un élément conducteur de chaleur (6a-h), un élément de conduite de fluide (8ah) et une masse de remplissage et/ou de collage (10a-h) conductrice de chaleur,
**caractérisé en ce**
**que** l'élément conducteur de chaleur (6a-h) se compose d'un matériau composite (12) et possède une zone d'accueil (14), l'élément de conduite de fluide (8a-h), dans sa direction longitudinale, est disposé au moins dans certaines portions au niveau de la zone d'accueil (14) et est relié à l'élément conducteur de chaleur (6ah) par le biais de la masse de remplissage et/ou de collage (10a-h), la masse de remplissage et/ou de collage (10a-h) remplissant au moins partiellement un interstice radial (16) entre l'élément de conduite de fluide (8a-h) et la zone d'accueil (14).

2. Arrangement d'équilibrage de la température d'un module solaire (4a, 4b) selon la revendication 1, **caractérisé en ce que** l'élément conducteur de chaleur (6a-h) est une pièce profilée (18) comprenant une goulotte (20) en tant que zone d'accueil (14) et au moins un côté de la goulotte (20) possède une branche (22) ayant une surface d'appui (24) qui est plane au moins dans certaines portions.

3. Arrangement d'équilibrage de la température d'un module solaire (4a, 4b) selon la revendication 1 ou 2, **caractérisé en ce que** le matériau composite (12) possède un silicate alcalin (52), notamment du Na₂SiO₃ ou du K₂SiO₃.

4. Arrangement d'équilibrage de la température d'un module solaire (4a, 4b) selon l'une des revendications précédentes, **caractérisé en ce que** le matériau composite (12) possède une substance ininflammable (56), notamment un sel de bore, un silicate d'aluminium, un hydroxyde d'aluminium, un phosphate, un gypse (58) et/ou un ciment.

5. Arrangement d'équilibrage de la température d'un module solaire (4a, 4b) selon l'une des revendications précédentes, **caractérisé en ce que** le matériau composite (12) possède des fibres (60) contenant de la cellulose ayant une longueur de 200 µm à 3000 µm.

6. Arrangement d'équilibrage de la température d'un module solaire (4a, 4b) selon la revendication 5, **caractérisé en ce que** le matériau composite (12) possède de l'aluminium (48) et la part massique des fibres (60) contenant de la cellulose est de 5 % à 20 % de la part massique de l'aluminium (48).

7. Arrangement d'équilibrage de la température d'un module solaire (4a, 4b) selon l'une des revendications précédentes, **caractérisé en ce que** la masse de remplissage et/ou de collage (10a-h) conductrice de chaleur possède une poudre de graphite en tant que substance conductrice de chaleur et un silicate alcalin, notamment du Na₂SiO₃ ou du K₂SiO₃.

8. Arrangement d'équilibrage de la température d'un module solaire (4a) selon l'une des revendications précédentes, **caractérisé en ce que** l'élément conducteur de chaleur (6a-d) possède une surface noircie (32) destinée à renforcer l'absorption du rayonnement et est orienté vers le côté soleil d'un boîtier de module (2) et recouvert par une plaque de recouvrement en verre (28), une couche d'air (30) se trouvant entre l'élément conducteur de chaleur (6a-d) et la plaque en verre (28).

9. Arrangement d'équilibrage de la température d'un module solaire (4b) selon l'une des revendications précédentes, **caractérisé en ce que** l'élément conducteur de chaleur (6e-h) est relié à une surface (42) dont il faut équilibrer la température d'un module photovoltaïque (40) .

10. Procédé de fabrication d'un arrangement d'équilibrage de la température d'un module solaire (4a, 4b) comprenant un élément conducteur de chaleur (6a-h) et un élément de conduite de fluide (8a-h),
**caractérisé en ce**
**que** l'élément conducteur de chaleur (6a-h) est formé à partir d'un matériau composite (12), est relié à l'élément de conduite de fluide (8a-h) au moyen d'une masse de remplissage et/ou de collage (10a-h) et est disposé dans un module solaire (2, 40).

11. Procédé selon la revendication 10, **caractérisé en ce que** l'élément de conduite de fluide (8e-h) est disposé sur une surface (42) dont il faut équilibrer la température d'un module photovoltaïque (40), la masse de remplissage et/ou de collage (10e-h) est incorporée dans une cavité d'accueil (14) de l'élément conducteur de chaleur (6e-h), la cavité d'accueil (14) de l'élément conducteur de chaleur (6e-h) remplie de la masse de remplissage et/ou de collage (10e-h) est pressée sur l'élément de conduite de fluide (8e-h) et une zone adjacente de la surface (42) dont il faut équilibrer la température et une liaison collée (38b) est ainsi établie entre l'élément de conduite de fluide (8e-h) et l'élément conducteur de chaleur (6e-h) et entre l'élément conducteur de chaleur (6e-h) et la surface (42) dont il faut équilibrer la température.

12. Procédé selon la revendication 10 ou 11, **caractérisé en ce que** plusieurs éléments de conduite de fluide (8e-h) sont disposés les uns à côté des autres sur la surface (42) dont il faut équilibrer la température et sont respectivement collés avec la surface (42) dont il faut équilibrer la température par un pressage d'un élément conducteur de chaleur (6e-h) muni de la masse de remplissage et/ou de collage (10e-h), les éléments de conduite de fluide (8e-h) sont reliés par des lignes de liaison (44a-f) et une conduite de fluide (46) d'un seul tenant continue, s'étendant notamment en forme de méandre, étant ainsi créé.

13. Procédé selon l'une des revendications 10 à 12, **caractérisé en ce que** la masse de remplissage et/ou de collage (10a-d) est incorporée dans une cavité d'accueil (14) de l'élément conducteur de chaleur (6a-d), l'élément de conduite de fluide (8a-d) est enfoncé dans la cavité d'accueil (14) pourvue de la masse de remplissage et/ou de collage (10a-d) et recouvert de masse de remplissage et/ou de collage (10a-d), une liaison collée (38a) étant établie entre l'élément conducteur de chaleur (6a-d) et l'élément de conduite de fluide (8a-d) et l'élément conducteur de chaleur (6a-d) ainsi pourvu de l'élément de conduite de fluide (8a-d) et de la masse de remplissage et/ou de collage (10a-d) est introduit dans un boîtier de module (2) de telle sorte que l'élément conducteur de chaleur (6a-d) est orienté vers le côté soleil du boîtier de module (2).

14. Procédé selon l'une des revendications 10 à 13, **caractérisé en ce que** le matériau composite (12) possède de l'aluminium (48, 50) sous la forme de particules, qui est chauffé (100) à au moins 250 °C en vue de former une couche d'oxyde, une suspension de mélange composée de l'aluminium (48, 50), d'eau et/ou d'un liant (54) est produite (110), la suspension de mélange est introduite (130) dans une matrice de compression, pressée (140), déshydratée (150) de préférence sous pression de pressage et un produit pressé est séché (160).

15. Procédé selon la revendication 14, **caractérisé en ce que** le produit pressé est malléabilisé (170) à une température de 400 °C à 650 °C pendant une durée d'au moins 10 minutes.
